# EUROPÄISCHE PATENTANMELDUNG

(11) **EP 0 905 781 A2**
(43) Veröffentlichungstag der Anmeldung: **31.03.1999**
(21) Anmeldenummer: 98115179.8
(22) Anmeldetag: 12.08.1998
(51) Int. Cl.: H01L 27/02, H01L 29/861

(54) **ESD-Schutzdiode**

(30) Priorität: 30.09.1997 DE 19743227
(71) Anmelder: SIEMENS AKTIENGESELLSCHAFT, 80333 München (DE)
(72) Erfinder: Gossner, Harald, Dr., 81735 München (DE); Stecher, Matthias, Dr., 9500 Villach (AT)

(57) **Zusammenfassung**

Die Erfindung betrifft eine integrierte Halbleiterschaltung mit einer Schutzstruktur zum Schutz vor elektrostatischer Entladung, wobei die Schutzstruktur vorzugsweise als vertikale Schutzdiode vorgesehen ist. Die vertikale Schutzdiode kann dabei ohne Veränderung der Prozeßführung zur Herstellung der integrierten Halbleiterschaltung durch maskierte Diffusion oder maskierte Ionenimplantation durch Veränderung der Querschnittsfläche der Öffnungen der Maskierungsschicht bzw. des Abstandes benachbarter Öffnungen variiert werden. Erfindungswesentlich für die Herstellung einer homogenen Dotierkonzentration im Diffusionsgebiet ist dabei, daß die Abstände benachbarter Öffnungen mindestens kleiner sind als die doppelte Diffusionslänge der eingebrachten Dotieratome. Als ESD-Schutzelement kann auch ein Transistor, insbesondere ein Bipolar-Transistor, ein Thyristor oder ein IGBT verwendet werden. In diesem Fall bildet die vertikale Schutzdiode die Ansteuerdiode dieser Bauelemente. Zusätzlich weist die ESD-Schutzstruktur im Randbereich der Diffusionszone Bereiche verringerter Durchbruchspannung aufgrund einer veringerten Dotierung auf.

## Beschreibung

Die Erfindung betrifft eine integrierte Halbleiterschaltung, die in zumindest einem Halbleiterkörper angeordnet ist, und folgende Merkmale aufweist:
a) mindestens einen Anschlußpad, das über eine elektrisch leitende Verbindungsleitung mit der integrierten Halbleiterschaltung verbunden ist,
b) mindestens eine erste Potentialschiene, die im Betrieb ein erstes Versorgungspotential der integrierten Halbleiterschaltung führt,
c) mindestens eine zweite Potentialschiene, die im Betrieb ein zweites Versorgungspotential der integrierten Halbleiterschaltung führt und
d) mindestens ein Schutzelement zum Schutz der integrierten Halbleiterschaltung vor elektrostatischen Entladung, wobei das Schutzelement zwischen das Anschlußpad und der integrierten Halbleiterschaltung angeordnet ist und an mindestens eine der Potentialschienen angeschlossen ist.

Ein derartiges sogenanntes ESD-Schutzelement ist aus J. Chen, X. Zhang, A. Amerasekera und T. Vrostos; Design and Layout of a High ESD Performance NPN Structure for Submicron BiCMOS/Bipolar Circuits, Proc. of the IEEE International Reliability Physics Symposium (1996), S. 227 bekannt.

In einem Chip integrierte Halbleiterschaltungen enthalten Schutzschaltungen zum Schutz der Ein- oder Ausgänge (I/O-Ports) gegen elektrostatische Überspannungen und dadurch verursachte elektrostatische Entladungen (Electrostatic Discharge (ESD)). Diese sogenannten ESD-Schutzelemente sind zwischen dem Eingangspad einer integrierten Halbleiterschaltung und dem zu schützenden Eingangs- oder Ausgangsanschluß angeschlossen und sorgen somit dafür, daß bei Einkopplung einer parasitären Überspannung das ESD-Schutzelement durchschaltet und der parasitäre Überspannungsimpuls somit an eine der Versorgungsspannungsleiterbahnen abgeleitet wird. Derartige Überspannungsimpulse können im Extremfall zur Zerstörung des Bauteiles führen.

Unter Operationsbedingungen, wie sie z. B. in der Produktspezifikation beschrieben sind, dürfen die ESD-Schutzelemente die Funktion der zu schützenden integrierten Halbleiterschaltungen jedoch nicht beeinträchtigen. Das bedeutet, daß die Durchschaltspannung der ESD-Schutzelemente außerhalb des Signalspannungsbereiches der geschützten Anschlußpads liegen muß. Um eine gute Schutzwirkung entfalten zu können, sollte das ESD-Schutzelement vor dem kritischsten Schaltungspfad durchbrechen. Dies erfordert in der Regel eine exakte Einstellung der Durchschaltspannung der jeweiligen ESD-Schutzelemente mit der wesentlichen Randbedingung, daß die Prozeßführung, die hinsichtlich der Eigenschaften der Bauelemente der zu schützenden integrierten Halbleiterschaltung optimiert wurde, durch das Einfügen der ESD-Schutzelemente nicht verändert wird.

Eine weitere wesentliche Randbedingung ergibt sich aus der räumlichen Anordnung der Anschlußpads in unmittelbarer Nähe der zu schützenden integrierten Halbleiterschaltung. Insbesondere werden die Anschlußpads wegen des relativ hohen zu treibenden Strom in der Nähe der Ausgangstreiber angeordnet. Die ESD-Schutzstruktur wird daher häufig an diejenige Versorgungsleitung angeschlossen, aus der der Ausgangstreiber versorgt wird.
Die Durchschaltspannung der ESD-Schutzelemente muß insbesondere im gesamten Betriebstemperaturbereich sowie unter Berücksichtigung der Streuung der elektrischen Parametern aufgrund von Schwankungen der Betriebsparameter in der Fertigung diese Grenzen einhalten.

Um der Einstellung der Durchbruchspannung der ESD-Schutzelemente ohne Änderung der Prozeßführung nachkommen zu können, erfolgt diese in der Regel durch Nutzung des lateralen Durchbruchs einer Diode, z. B. durch Wahl eines bestimmten Maskenabstands von p- und n-Diffusionsgebiet einer lateralen Diode. Eine derartige laterale ESD-Schutzdiode weist jedoch den wesentlichen Nachteil eines sehr großen Bahnwiderstandes auf.

Desweiteren ergeben sich relativ große Schwankungen der elektrischen Parameter, insbesondere der Durchschaltspannung, aufgrund von großen Fertigungsschwankungen sowie aufgrund von Justierungenauigkeiten der Masken zueinander. Insbesondere bei sehr flachen Halbleiterstrukturen weisen die ESD-Schutzelemente eine sehr geringe ESD-Festigkeit aufgrund eines oberflächennahen Durchbruchs auf.

Diese oben genannten Nachteile treten insbesondere bei ESD-Schutzelementen mit hohen Signalspannungsbereichen, wie sie beispielsweise in der Smart-Power-Technologie auftreten, auf.

Bezüglich weiterer Einzelheiten, Merkmale, deren Vorteile und Wirkungsweise der ESD-Schutzschaltungen wird ausdrücklich auf die Europäische Patentanmeldung EP 0 623 958 A1 sowie auf das eingangs genannte Dokument von J. Chen et al. verwiesen und vollinhaltlich Bezug genommen ( 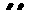 incorporated by reference").

Ausgehend von diesem Stand der Technik liegt der Erfindung daher die Aufgabe zugrunde, eine ESD-Schutzelemente der eingangs genannten Art bereitzustellen, bei der die Durchschaltspannung exakt einstellbar ist.

Erfindungsgemäß wird diese Aufgabe gelöst durch ein Schutzelement, das gekennzeichnet ist durch
e) mindestens eine erste Zone vom ersten Leitungstyp, die als vergrabene Schicht im Halbleiterkörper vorgesehen ist und mit dem Anschlußpad oder einer der Potentialschienen verbunden ist, und durch
f) mindestens eine zweite Zone vom zweiten Leitungstyp, die in den Halbleiterkörper hineinragt, an die erste Zone angeschlossen ist und mit mindestens einer der Potentialschienen oder dem Anschlußpad verbunden ist.

Erfindungsgemäß wird eine vertikal ausgebildete ESD-Schutzstruktur angegeben, deren Durchschaltspannung ohne Veränderung der Prozeßführung zur Herstellung der integrierten Halbleiterschaltung exakt einstellbar ist.

Die ESD-Schutzstruktur weist dabei im wesentlichen eine vertikale pn-Diode auf, deren erste Zone typischerweise durch eine vergrabene Schicht (ein sogenanntes burried layer) und deren zweite Zone durch eine Diffusionszone gebildet wird. Erfindungsgemäß läßt sich die Dotierungskonzentration der zweiten Zone exakt einstellen. Dadurch läßt sich auch die Durchschaltspannung dieser vertikalen Diode exakt einstellen.

Die zweite Zone kann gemäß den oben genannten Randbedingungen während der Herstellung der integrierten Halbleiterschaltung erzeugt werden. Somit ist vorteilhafterweise kein zusätzlicher Prozeßschritt und damit keine Veränderung der Prozeßführung bei der Herstellung der integrierten Halbleiterschaltung nötig.

Derartige vertikale Schutzstrukturen weisen einen wesentlich geringeren Bahnwiderstand gegenüber entsprechenden, lateral ausgebildeten Schutzstrukturen auf.

Justierungenauigkeiten, die beispielsweise bei lateralen Strukturen eine große Rolle spielen, können bei solchen vertikalen Schutzstrukturen weitgehend vernachlässigt werden.

Schließlich erweist sich ein vertikaler Spannungsdurchbruch aufgrund der wesentlich geringeren zu tragenden Stromdichten als sehr viel robuster wie ein entsprechender lateraler Spannungsdurchbruch.

Typischerweise bildet die pn-Diode aus der ersten und zweiten Zone eine in die Halbleiterschaltung integrierte vertikale ESD-Schutzdiode.

In einer vorteilhaften Weiterbildung kann diese vertikale pn-Diode auch als Ansteuerdiode eines integrierten Transistors dienen. Typischerweise ist dieser ESD-Schutztransistor bipolar realisiert. Es ist jedoch auch denkbar, jede andere Form von gesteuerten Transistoren, wie beispielsweise ein MOSFET bzw. ein Sperrschichttransistor, als ESD-Schutzelement zu verwenden.

In einer Weiterbildung ist es auch denkbar, die pn-Diode als Ansteuerdiode für einen Thyristor, einen IGBT oder ähnlichem zu verwenden.

Die exakte Einstellung der Durchschaltspannung des ESD-Schutzelementes erfolgt erfindungsgemäß durch eine geeignet dimensionierte Dotierungsmaske. Die Dotierungsmaske kann dabei durch ein gängiges Feldoxid, das beispielsweise in LOCOS-Technologie hergestellt ist, gebildet sein. Als Dotierungsmaske kann jedoch auch jede andere Maskierung, wie zum Beispiel ein Photolack, dienen.

Die Dotierungsmaske ist derart strukturiert, daß sie eine Vielzahl von Öffnungen mit der Querschnittsfläche A aufweist. Typischerweise sind die Öffnungen äquidistant mit dem Abstand zueinander angeordnet. Erfindungswesentlich ist dabei, daß der maximale Abstand d benachbarter Öffnungen kleiner ist als die doppelte Diffusionslänge der für die Diffusionszone vorgesehenen Dotieratome. Unter Verwendung dieser Dotierungsmaske werden die Dotieratome in die Bereiche der Diffusionszone eingebracht. Bei der Diffusion verteilen sich die Dotieratome lateral und vertikal homogen gleichmäßig über die Diffusionszone.

Es ist auch denkbar, die Dotieratome durch Ionenimplantation in den Halbleiterkörper einzubringen. Die Ionenimplantation erweist sich gegenüber der Diffusion als vorteilhaft, da hier eine exakt meßbare Dotierdosis in den Halbleiterkjörper einbringbar ist. Jedoch ist bei der Ionenimplantation darauf zu achten, daß im Anschluß an die Ionenimplantation ein geeigneter Temperaturschritt angeschlossen wird, damit zum einen die Dotieratome elektrisch aktiviert werden und Kristallschäden ausgeheilt werden und zum anderen sich die Dotieratome homogen gleichmäßig über die Bereiche der Diffusionszone verteilen. Besonders vorteilhaft erweist sich an dieser Stelle eine Hochtemperaturionenimplantation, da hier auf den Temperaturschritt verzichtet werden kann.

Über die Querschnittsfläche der Öffnungen sowie über den Abstand benachbarter Öffnungen läßt sich die Dotierungskonzentration in der zweiten Zone und somit die Durchbruchspannung am pn-Übergang exakt einstellen. Dies erfolgt vorteilhafterweise ohne Veränderung der Prozeßparameter bzw. der Prozeßführung zur Herstellung der integrierten Halbleiterschaltung.

Besonders vorteilhaft ist es, wenn die Öffnungen eine identische Querschnittsfläche aufweisen und deren Abstand in Richtung der Randzone der Dotiermaske kontinuierlich abnimmt. Alternativ ist es ebenfalls vorteilhaft, wenn die Öffnungen in äquidistantem Abstand zueinander angeordnet sind und deren Querschnittsfläche in Richtung der Randzone der Dotiermaske kontinuierlich abnimmt. Im vorliegenden Beispiel der Dotierungsmaske 16 sind die Öffnungen 13 äquidistant angeordnet und weisen jeweils eine gleiche Querschnittsfläche A auf. Dies ist jedoch nicht zwingend notwenig. Auf diese Weise läßt sich ein inhomogenes Dotierungsprofil im Randbereich der Diffusionszone erzeugen. Ein derartiger flacher pn-Übergang am seitlichen Rand zwischen Diffusionszone und Epitaxieschicht hat eine höhere Durchbruchspannung dieser parasitären Diode zur Folge, wodurch dort ein lokaler Durchbruch vermieden wird.

Durch diese Maßnahme weisen die Randbereiche der Diffusionszone 9, die seitlich unmittelbar an die Epiaxieschicht 18 angrenzen, eine nach außen sich veringernde Dotierungskonzentration auf, wodurch dort ein flacherer pn-Übergang erzeugt wird., sondern daß der Durchbruch ausschließlich am pn-Übergang 13 zwischen Diffusionsgebiet 9 und vergrabener Schicht 8 erfolgt.

Besonders vorteilhaft ist die Erfindung bei Verwendung in einem Halbleiterspeicher bzw. einem Logikbauteil. Eine weitere vorteilhafte Anwendung findet die Erfindung in Verwendung in einem Microcontroller. Die integrierte Halbleiterschaltung kann dabei bipolar, in MOS-Technologie oder ähnlichem realisiert sein.

Nachfolgend wird die Erfindung anhand der in den Figuren der Zeichnung angegebenen Ausführungsbeispiele näher erläutert. Es zeigt dabei:
- Figur 1: die Schaltungsanordnung einer bekannten integrierten Halbleiterschaltung mit vorgeschaltetem ESD-Schutzelement, das hier als Diode ausgebildet ist;
- Figur 2: eine schematische Darstellung der Realisierung einer ESD-Schutzdiode in einem Halbleitersystem;
- Figur 3: einen Ausschnitt der in Figur 2 gezeigten Struktur, die das Herstellungsverfahren der erfindungsgemäßen Struktur veranschaulicht;
- Figur 4: eine Draufsicht der in Figur 3 gezeigten Struktur.

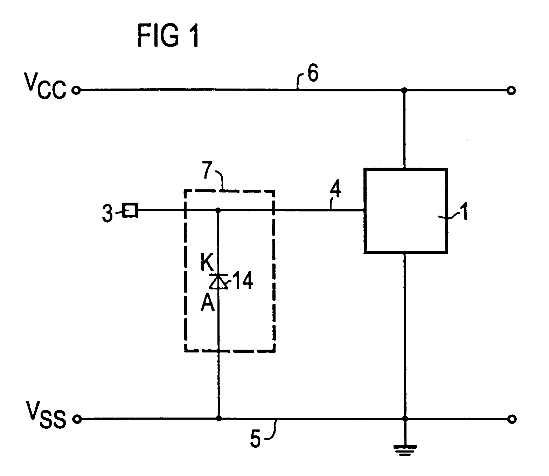

Figur 1 zeigt eine Schaltungsanordnung einer bekannten integrierten Halbleiterschaltung mit vorgeschaltetem ESD-Schutzelement.

In Figur 1 ist mit 1 die integrierte Halbleiterschaltung bezeichnet. Die integrierte Halbleiterschaltung 1 ist an eine erste Potentialschiene 5 mit einem ersten Versorgungspotential VSS sowie eine zweite Potentialschiene 6 mit einem zweiten Versorgungspotential VCC angeschlossen. Das erste Versorgungspotential VSS ist im vorliegenden Beispiel die Bezugsmasse. Das zweite Versorgungspotential VCC kann die Versorgungsspannung sein.

Über eine Verbindungsleitung 4 ist die integrierte Halbleiterschaltung 1 mit einem Anschlußpad 3 verbunden. Der Anschlußpad 3 kann sowohl ein Eingangsanschluß zur Einkopplung von Eingangssignalen in die integrierte Halbleiterschaltung 1 sein, als auch ein Ausgangsanschluß zum Auskoppeln von Ausgangssignalen aus der integrierten Halbleiterschaltung 1. Derartige Anschlüsse werden auch als I/O-Ports bezeichnet.

Zwischen dem Anschlußpad 3 und der integrierten Halbleiterschaltung 1 ist ein ESD-Schutzelement 7 geschaltet. Im vorliegenden Fall ist das ESD-Schutzelement 7 eine ESD-Schutzdiode 14. Das ESD-Schutzelement 7 kann jedoch auch durch einen bipolar realisierten Transistor, einen gesteuerten Transistor, insbesondere einen MOSFET- oder Sperrschicht-FET, einen Thyristor, ein IGBT oder ähnlichem realisiert sein.

Diese ESD-Schutzdiode 14 ist kathodenseitig mit der Verbindungsleitung 4 und anodenseitig mit der ersten Potentialschiene 5 verbunden. Es ist jedoch auch denkbar, daß das ESD-Schutzelement zwischen der Verbindungsleitung 4 und der zweiten Potentialschiene 6 angeordnet ist. Das ESD-Schutzelement 7 soll die integrierte Halbleiterschaltung 1 vor parasitären, über das Anschlußpad 3 eingekoppelte Signale schützen. Diese parasitären Störsignale werden durch das ESD-Schutzelement 7 an eine der Potentialschienen 5, 6 abgeleitet und gelangen somit nicht in die integrierte Halbleiterschaltung 1.

Derartige Störsignale können beispielsweise beim Transport bzw. beim Handling des Halbleiterchips entstehen. Dadurch kann der Halbleiterchip elektrostatisch aufgeladen werden. Wird diese elektrostatische Ladung in die integrierte Halbleiterschaltung 1 eingekoppelt, kann dies im Extremfall zur Zerstörung des Bauteils führen.

Unter Operationsbedingungen dürfen jedoch die ESD-Schutzelemente 7 die Funktion der integrierten Halbleiterschaltung 1 nicht beeinträchtigen. Die Durchschaltspannung der ESD-Schutzelemente 7 muß dabei in einem Spannungsbereich liegen, deren untere Grenze die maximal in die integrierte Halbleiterschaltung 1 eingekoppelte Signalspannung ist, und deren obere Grenze durch die minimale Durchbruchspannung der integrierten Halbleiterschaltung 1 gekennzeichnet ist.

In Smart-Power-Technologie hergestellte integrierte Halbleiterschaltungen 1 weisen beispielsweise eine untere Grenze von 40 V und eine obere Grenze von 50 V auf. Die Durchschaltspannung der ESD-Schutzelemente 7 sollte idealerweise möglichst genau zwischen diesen Spannungswerten liegen. Maßgeblich dabei ist, daß die Durchschaltspannung der ESD-Schutzelemente 7 möglichst exakt einstellbar ist, um so trotz Prozeßschwankungen bei der Herstellung der integrierten Halbleiterschaltung 1 und des ESD-Schutzelements 7 funktionsfähig zu sein.

Zur Simulierung einer Störsignaleinkopplung wird typischerweise das sogenannte Human-Body-Modell (HBM) angewendet. Das Ersatzschaltbild des Human-Body-Modells sieht einen Tiefpaß, bestehend aus einer Kapazität von 100 pF und einem Widerstand von 1,5 KΩ vor. Das Human-Body-Modell simuliert ein durch einen Menschen eingekoppeltes Störsignal. Es ist auch denkbar, andere Modelle wie beispielsweise das sogenannte Charged-Device-Modell (CDM) zu verwenden.

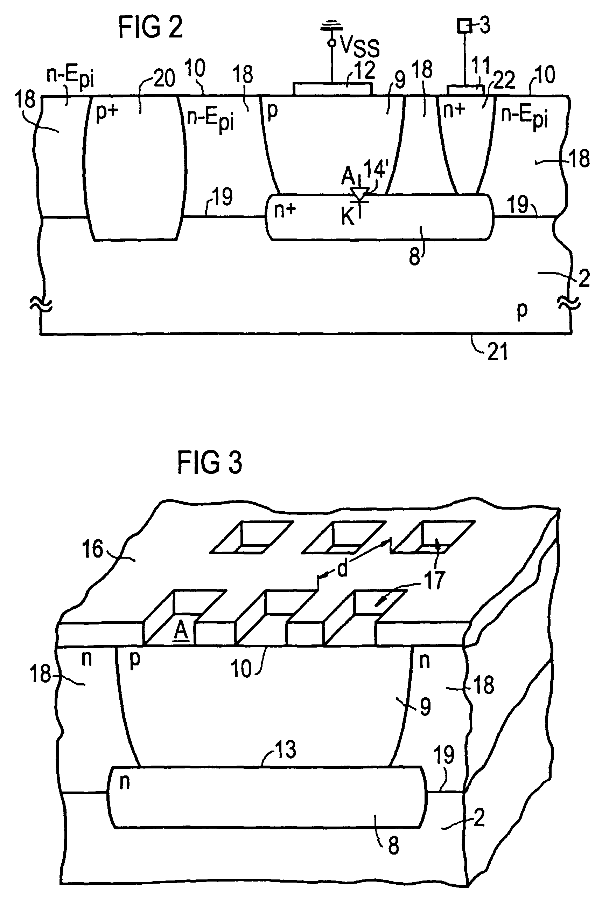

Figur 2 zeigt eine schematische Darstellung der Realisierung eines ESD-Schutzelements, das im vorliegenden Beispiel als ESD-Schutzdiode ausgeführt ist. Gleiche Elemente sind entsprechend Figur 1 mit gleichen Bezugszeichen versehen.

In Figur 2 ist mit 2 ein Halbleiterkörper bezeichnet. Der Halbleiterkörper 2 besteht typischerweise aus Siliciumsubstrat. Der Halbleiterkörper 2 weist eine Scheibenrückseite 21 und eine Substratoberfläche 19 auf. Im vorliegenden Beispiel ist das Siliciumsubstrat des Halbleiterkörpers 2 p-dotiert und liegt auf der Scheibenrückseite 21 auf dem Substratpotential. Es ist jedoch auch denkbar, daß das Halbleitersubstrat n-dotiert ist.

Auf der Seite der Substratoberfläche 19 ist eine schwach n-dotierte Epitaxieschicht 18 angeordnet. Für die Funktion der ESD-Schutzstruktur wäre es auch denkbar mehrere Epitaxieschichten 18 übereinander anzuordnen oder auf die Epitaxieschicht 18 ganz zu verzichten. Die Dotierungskonzentration in der Epitaxieschicht 18 hängt von den durch die Prozeßführung zur Herstellung der integrierten Halbleiterschaltung 1 vorgegebenen Parametern ab. Typischerweise weist die Epitaxieschicht eine Dotierungskonzentration von 1*10¹⁵ cm⁻³ bis 1*10¹⁸ cm⁻³ auf

Zusätzlich ist in Figur 2 eine Pufferschicht 20 vorgesehen, die sich von der Scheibenvorderseite 10 durch die gesamte Epitaxieschicht 18 bis in den Halbleiterkörper 2 hinein erstreckt. Im vorliegenden Beispiel ist die Pufferschicht 20 p⁺-dotiert. Die Pufferschicht 20 kann jedoch auch durch jedes andere gängige Puffermaterial, beispielsweise Siliciumdioxid, Siliciumnitrit oder ähnlichem, gebildet werden. Die Pufferschicht 20 hat üblicherweise die Funktion der Schirmung bzw. der Trennung der ESD-Struktur gegenüber der integrierten Halbleiterschaltung bzw. dem Halbleiterchip.

Es ist besonders vorteilhaft, wenn die in Flußrichtung gepolte pn-Diode zwischen vergrabener Schicht 8 und p-dotiertem Substrat 2 genutzt wird, um beispielsweise negative Pulse abzuführen. Diese negativen Pulse können dann über die p-dotierte Pufferschicht 20 abgeleitet werden.

Zusätzlich ist, wie in Figur 2 gezeigt, eine vergrabene Schicht 8 vorgesehen. Eine derartige vergrabene Schicht 8 wird auch als Burried Layer bezeichnet. Im vorliegenden Beispiel ist diese vergrabene Schicht n⁺-dotiert. Diese n⁺-dotierte vergrabene Schicht 8 kann beispielsweise durch Einbringen eines Dotierungsdepots auf der Substratoberfläche 19 vor Aufwachsen der Epitaxieschicht 18 und anschließender Diffusion bei geeigneter Temperatur erzeugt werden.

Es ist jedoch auch vorteilhaft, wenn die vergrabene Schicht 8 durch Ionenimplantation erzeugt wird. Um das gewünschte vertikale Profil zu erzielen, wird dabei häufig eine Mehrfachimplantation bei geeigneten Energien und Dotierungsdosen durchgeführt. Anschließend sollte ein geeigneter Temperaturschritt angeschlossen werden, um einerseits Kristallschäden auszuheilen andererseits eine homogene Verteilung der Dotierstoffe im Halbleiterkörper 1 zu erzielen.

Die Dotierungskonzentration in der vergrabenen Schicht 8 hängt ebenfalls weitgehend von der Prozeßführung bei der Herstellung der integrierten Halbleiterschaltung 1 ab. Typischerweise weist die vergrabene Schicht 8 eine Dotierungskonzentration von größer 1*10¹⁹ cm⁻³ auf.

Erfindungsgemäß ist eine p-dotierte Diffusionszone 9 vorgesehen. Die p-dotierte Diffusionszone 9 erstreckt sich im vorliegenden Beispiel von der Scheibenvorderseite 10 aus in die Epitaxieschicht 18 hinein und ist an die vergrabene Schicht 8 über einen pn-Übergang 13 angeschlossen. Vorteilhafterweise wird die p-dotierte Diffusionszone 9 durch Diffusion bei geeigneter Temperatur in den Halbleiterkörper 2 eingebracht.

Die Diffusionszone 9 ist an der Scheibenvorderseite 10 über eine Anodenelektrode 12 mit dem ersten Versorgungspotential VSS bzw. Masse verbunden. Entsprechend ist die vergrabene Schicht 8 über eine n⁺-dotierte Anschlußzone 22 an der Scheibenvorderseite 10 über eine Kathodenelektrode 11 mit dem Anschlußpad 3 verbunden.

Der pn-Übergang 13 zwischen der Diffusionszone 9 und der vergrabenen Schicht 8 definiert eine vertikale ESD-Schutzdiode 14'. Die Durchschaltspannung dieser vertikalen ESD-Schutzdiode 14' ergibt sich im wesentlichen aus den Dotierungskonzentrationen des Diffusionsgebietes 9 und der vergrabenen Schicht 8. Die Dotierungskonzentration der vergrabenen Schicht 8 ist jedoch durch die Prozeßführung festgelegt und kann somit nicht verändert werden. Erfindungsgemäß läßt sich jedoch anodenseitig der ESD-Schutzdiode 14' über die Dotierungskonzentration des p-dotierten Diffusionsgebietes 9 die Durchschaltspannung der ESD-Schutzdiode genau einstellen. Die Dotierungskonzentration in der Diffusionszone 9 hängt somit von der angestrebten Durchbruchspannung der ESD-Schutzdiode 14' ab.

Typischerweise ist die laterale Querschnittsfläche der vergrabenen Schicht 8 größer als die laterale Querschnittsfläche des Diffusionsgebiets 9. Die laterale Fläche der Diffusionszone 9 und der vergrabenen Schicht 8 ist aus praktischen Gründen quadratisch oder rechteckförmig ausgebildet. Es ist jedoch auch vorteilhaft, wenn diese Zonen 8, 9 kreisförmig bzw. rund ausgebildet sind.

Das in Figur 1 mit 7 bezeichnete Schutzelement kann selbstverständlich auch durch einen Transistor, insbesondere einen Bipolar-Transistor oder einen MOS-FET, einen Thyristor oder einen IGBT realisiert sein. In diesem Fall bildet die in Figur 2 mit 14' bezeichnete vertikale Diode die Ansteuerdiode dieser Bauelemente.

Nachfolgend wird die Funktionsweise der erfindungsgemäßen vertikalen ESD-Schutzstruktur näher erläutert.

Wird über das Anschlußpad 3 ein Störsignal eingekoppelt und überschreitet dieses Störsignal die Schaltschwelle der vertikalen Schutzdiode 14', dann bricht die Raumladungszone am p-n-Übergang des pn-Überganges 13 zwischen Diffusionsgebiet 9 und vergrabener Schicht 8 zusammen und die Schutzdiode 14' schaltet durch. Somit ergibt sich ein Strompfad vom Anschlußpad 3 über die Anschlußzone 22, die vergrabene Schicht 8 und dem Diffusionsgebiet 9 zur ersten Potentialschiene 5. Das Störsignal wird somit auf die erste Potentialschiene abgeleitet und gelangt somit in die integrierte Halbleiterschaltung 1.

Erfindungswesentlich ist dabei, daß die Diffusionszone 9 im gesamten Bereich homogen dotiert ist. Zur exakten Einstellung der Durchschaltspannung der Schutzdiode 14' ist es erfindungswesentlich, daß die Dotierungskonzentration im Diffusionsgebiet 9 möglichst exakt einstellbar ist.

Um diesen Anforderungen genüge zu leisten, wird nachfolgend das erfindungsgemäße Herstellungsverfahren für die Diffusionszone 9 anhand von Figur 3 der Zeichnung näher erläutert.

Figur 3 zeigt ausschnittsweise die schematische Darstellung der Eingangsschutzsstruktur entsprechend Figur 2. Dabei sind gleiche Elemente mit gleichen Bezugszeichen versehen.

In Figur 3 ist mit 16 eine Dotierungsmaske bezeichnet. Die Dotierungsmaske 16 hat die Form einer Dotierungsmaske mit einer Vielzahl von Öffnungen 17. Die Öffnungen 17 sind derart angeordnet, daß benachbarte Öffnungen 17 einen maximalen Abstand d aufweisen. Die Öffnungen 17 haben im vorliegenden Beispiel die Form von Rechtecken mit der Querschnittsfläche A. Die Öffnungen in der Dotierungsmaske sind typischerweise quadratisch oder rechteckig. Sie können aber auch kreisrund, kreisförmig, vieleckig, streifenförmig, o. ä. ausgebildet sein.

Im vorliegenden Beispiel ist die Dotierungsmaske 16 auf der Oberfläche der Scheibenvorderseite 10 aufgebracht. Besonders vorteilhaft ist es, wenn die Dotierungsmaske 16 aus Siliciumdioxid besteht. In diesem Fall kann sie über eine einfache strukturierte Oxidation aufgewachsen werden. Besonders vorteilhaft ist hierbei die sogenannte LOCOS-Technologie (Local Oxidation of Silicon). Selbstverständlich läßt sich die Dotierungsmaske 16 auch durch eine gängige andere Masikierung, wie z. B. Photolack, realisieren.

Die Dotierungsmaske 16 ist auf der Oberfläche der Scheibenvorderseite 10 des Halbleiterkörpers 2 derart angeordnet, daß sich deren Öffnungen 17 in den Bereichen der Scheibenoberfläche 10 befinden, in denen die gewünschte Diffusionszone 9 erzeugt werden soll. Nach Aufbringen der Dotierungsmaske 16 erfolgt eine Diffusion. Die Diffusionsparameter werden durch die für die Herstellung der integrierten Halbleiterschaltung 1 vorgesehenen Prozeßparameter bestimmt. Das bedeutet, daß die Art der Dotieratome, die Dotierdosis, die Dotierzeit sowie die Diffusionstemperatur durch die Prozeßführung zur Herstellung der integrierten Halbleiterschaltung 1 vorgegeben sind. Nach der Diffusion wird die Dotierungsmaske 16, beispielsweise durch eine Naßätzung, wieder entfernt. Hieran kann gegebenenfalls ein weiterer Temperaturschritt, beispielsweise zur homogenen Verteilung der Dotieratome im Diffusionsgebiet 9, angeschlossen werden.

Es wäre auch denkbar, das Diffusionsgebiet 9 statt durch Diffusion durch Ionenimplantation zu erzeugen. Es ist jedoch dann darauf zu achten, daß im Anschluß an die Ionenimplantation sowohl ein erster Temperaturschritt zum Ausheilen bzw. elektrischen Aktivieren der Dotieratome im Halbleiterkörper 2 vorzusehen ist, als auch ein zweiter Temperaturschritt, bei dem die Dotieratome, die sich bei der Ionenimplantation ausschließlich in den Bereichen unterhalb der Öffnungen 17 befinden, sich homogen in dem gesamten Bereich der Diffusionszone 9 verteilen.

Besonders vorteilhaft wäre eine Hochtemperaturionenimplantation, bei der die eingebrachten Dotieratome schon während der Implantation durch In-Situ-Tempern sowohl elektrisch aktiviert als auch homogen im Halbleiterkörper 2 verteilt werden.

Die Ionenimplantation erweist sich gegenüber der Diffusion als vorteilhaft, da hier die Dotierdosis und somit die in den Halbleiterkörper 2 eingebrachte Dotierkonzentration exakt einstellbar ist.

Zur homogenen Verteilung der Dotieratome im Halbleiterkörper 2 ist es erfindungswesentlich, daß der Abstand d benachbarter Öffnungen 17 in der Dotierungsmaske 16 kleiner ist, als die doppelte Diffusionslänge der entsprechenden Dotieratome. Bei größeren Abständen d der Öffnungen 17 würde sich eine inhomogene Verteilung der Dotieratome im Diffusionsgebiet 9 ergeben. Insbesondere würden sich dann jeweils unter den Öffnungen 17 zapfenförmige Bereiche mit inhomogener Verteilung der Dotierkonzentration ausbilden. Diese zapfenförmigen Bereiche würden zu einer inhomogenen Verteilung der Stromdichten und somit zu einer inhomogenen Verteilung der Durchbruchspannung am pn-Übergang 13 zwischen Diffusionsgebiet 9 und vergrabenem Gebiet 8 führen. Die Durchschaltspannung ließe sich damit nicht genau einstellen.

Da die Diffusionsparameter, hierbei insbesondere die Diffusionszeit und die Diffusionsdosis, durch die Prozeßführung zur Herstellung der integrierten Halbleiterschaltung 1 vorgegeben sind, ist es daher erfindungswesentlich, daß die Dotierungskonzentration im Diffusionsgebiet 9 ohne Veränderung der Prozeßführung exakt einstellbar ist. Nur dann ist eine exakt einstellbare Durchschaltspannung der ESD-Schutzelemente 7 möglich. Erfindungsgemäß ist dies durch Veränderung der Querschnittsfläche A der Öffnungen 17 sowie durch Variation des Abstands d benachbarter Öffnungen möglich. Durch geeignete Variierung mindestens eines dieser Parameter läßt sich die Konzentration der in die Diffusionszone 9 eingebrachten Dotieratome genau einstellen.

Nach der Herstellung des Diffusionsgebietes 9 lassen sich in bekannter Weise die Anschlußelektroden 11, 12 sowie die Passivierungsschichten auf die Oberfläche 10 des Halbleiterkörpers 2 herstellen.

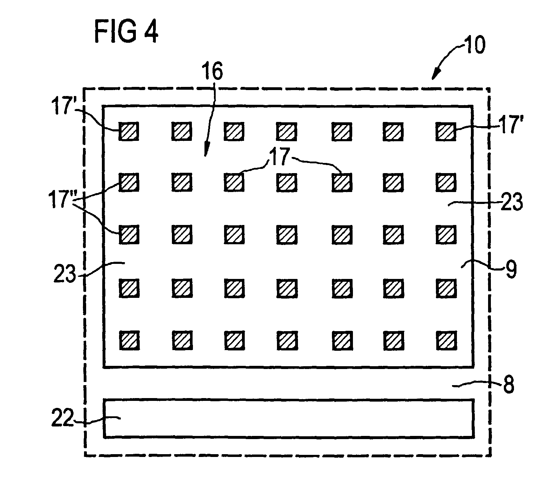

Figur 4 zeigt eine Draufsicht der in Figur 3 gezeigten Struktur. Die Öffnungen 17 der Dotierungsmaske 16 (nicht dargestellt) befinden sich auf der Scheibenoberfläche 10 in dem Bereich der Diffusionszone 9. Desweiteren ist in Figur 4 die Lage der vergrabenen Schicht 8 gestrichelt angedeutet. Mit 22 ist die Anschlußzone bezeichnet.

Wie in Figur 4 gezeigt, ist das Diffusionsgebiet 9 rechteckig ausgebildet. Um eine homogene Verteilung des elektrischen Feldes zu erzielen, ist es vorteilhaft, daß das Diffusionsgebiet 9 an seinen Kanten bzw. Ecken rund ausgeformt ist sowie in diesen Bereichen eine geringere Dotierungskonzentration aufweist. Aus diesen Gründen ist es vorteilhaft, wenn die Öffnungen 17' in den Ecken des herzustellenden Diffusionsgebiets 9 weggelassen werden. Die Öffnungen 17'' in der Randzone 23 der Dotiermaske 16 könnten beispielsweise eine geringere Querschnittsfläche A als die übrigen Öffnungen 17 aufweisen.

Durch diese Maßnahme weisen die Randbereiche der Diffusionszone 9, die seitlich unmittelbar an die Epiaxieschicht 18 angrenzen, eine nach außen sich veringernde Dotierungskonzentration auf, wodurch dort ein flacherer pn-Übergang erzeugt wird. Ein derartiger flacher pn-Übergang am seitlichen Rand zwischen Diffusionszone 9 und Epitaxieschicht 18 hat eine höhere Durchbruchspannung dieser parasitären Diode zur Folge. Dadurch wird gewährleistet, daß es zu keinem ungewollten lokalen Durchbruch dieser parasitären Diode kommt, sondern daß der Durchbruch ausschließlich am pn-Übergang 13 zwischen Diffusionsgebiet 9 und vergrabener Schicht 8 erfolgt.

Im vorliegenden Beispiel der Dotierungsmaske 16 sind die Öffnungen 13 äquidistant angeordnet und weisen jeweils eine gleiche Querschnittsfläche A auf. Dies ist jedoch nicht zwingend notwenig. Insbesondere für die Herstellung einer inhomogenen Dotierungskonzentration im Randbereich der Diffusionszone 9 sind auch nachfolgende Möglichkeiten denkbar:
- Die Dotierungsmaske 16 weist eine Vielzahl von Öffnungen 17 mit konstanter Querschnittsfläche A auf. Der Abstand d der Öffnungen 17 nimmt jedoch in Richtung der Randzone 23 der Dotiermaske 16 kontinuierlich ab.
- Die Dotierungsmaske 16 weist eine Vielzahl von Öffnungen 17 mit äquidistantem Abstand d auf. Jedoch verringert sich die Querschnittsfläche A der Öffnungen 17 in Richtung der Randzone 23 der Dotiermaske 16 kontinuierlich.

Auf diese Weise läßt sich ein nach außen hin verringerndes inhomogenes Dotierungsprofil erzeugen. Diese Methoden sind in der EP 0 176 778 B1 ausführlich beschrieben und es wird vollinhaltlich darauf Bezug genommen ( 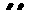 incorporated by reference").

Besonders vorteilhaft ist die Erfindung bei Verwendung des ESD-Schutzelements in einem Mikrokontroller, in einem Halbleiterspeicher oder in einem Logikbauteil.

Die integrierte Halbleiterschaltung sowie das dazugehörige ESD-Schutzelement sind dabei vorzugsweise bipolar realisiert bzw. in Smart-Power-Technologie hergestellt. Besonders vorteilhaft ist es jedoch, wenn die integrierte Halbleiterschaltung 1 sowie die ESD-Schutzschaltung in CMOS-Technologie hergestellt ist.

### Bezugszeichenliste

- 1: = integrierte Halbleiterschaltung
- 2: = Halbleiterkörper
- 3: = Anschlußpad
- 4: = Verbindungsleitung
- 5: = erste Potentialschiene
- 6: = zweite Potentialschiene
- 7: = ESD-Schutzelement
- 8: = erste Zone, vergrabene Schicht
- 9: = zweite Zone, Diffusionszone
- 10: = Scheibenvorderseite
- 11: = Kathodenelektrode
- 12: = Anodenelektrode
- 13: = pn-Übergang
- 14: = ESD-Schutzdiode
- 14': = integrierte, vertikale Schutzdiode
- 15: = integrierter (vertikaler) Transistor
- 16: = Maske, Dotierungsmaske
- 17,17',17'': = Öffnungen in der Maske
- 18: = Epitaxieschicht
- 19: = Substratoberfläche
- 20: = Pufferschicht
- 21: = Scheibenrückseite
- 22: = Anschlußzone
- 23: = Randzone der Dotiermaske
- A: = Querschnittsfläche der Öffnungen
- d: = Abstand benachbarter Öffnungen
- VCC: = zweites Versorgungspotential
- VSS: = erstes Versorgungspotential

## Patentansprüche

1. Integrierte Halbleiterschaltung (1), die in einem Halbleiterkörper (2) angeordnet ist,
a) mit mindestens einem Anschlußpad (3), das über eine elektrisch leitende Verbindungsleitung (4) mit der integrierten Halbleiterschaltung (1) verbunden ist,
b) mit mindestens einer ersten Potentialschiene (5), die im Betrieb ein erstes Versorgungspotential (VSS) der integrierten Halbleiterschaltung (1) führt,
c) mit mindestens einer zweiten Potentialschiene (6), die im Betrieb ein zweites Versorgungspotential (VCC) der integrierten Halbleiterschaltung (1) führt,
d) mit mindestens einem Schutzelement (7) zum Schutz der integrierten Halbleiterschaltung (1) vor elektrostatischer Entladung, wobei das Schutzelement (7) zwischen das Anschlußpad (3) und der integrierten Halbleiterschaltung (1) angeordnet ist und an mindestens eine der Potentialschienen (5, 6) angeschlossen ist,
**dadurch gekennzeichnet,** daß das Schutzelement (7)
e) mindestens eine erste Zone (8) vom ersten Leitungstyp, die als vergrabene Schicht im Halbleiterkörper (2) vorgesehen ist und mit dem Anschlußpad (3) oder einer der Potentialschienen (5, 6) verbunden ist, und
f) mindestens eine zweite Zone (9) vom zweiten Leitungstyp, die in den Halbleiterkörper (2) hineinragt, an die erste Zone (8) angeschlossen ist und mit mindestens einer der Potentialschienen (5, 6) oder dem Anschlußpad (3) verbunden ist, umfasst.

2. Integrierte Halbleiterschaltung nach Anspruch 1,
**dadurch gekennzeichnet,** daß die zweite Zone (9) eine weitgehend homogene Dotierungskonzentration aufweist.

3. Integrierte Halbleiterschaltung nach einem der vorhergehenden Ansprüche,
**dadurch gekennzeichnet,** daß als Schutzelement (7) eine integrierte, vertikale Diode (14') vorgesehen ist, die aus der ersten Zone (8) und der zweiten Zone (9) gebildetet ist.

4. Integrierte Halbleiterschaltung nach einem der Ansprüche 1 bis 2,
**dadurch gekennzeichnet,** daß als Schutzelement (7) ein integrierter Transistor vorgesehen ist, der durch die aus der ersten Zone (8) und der zweiten Zone (9) gebildeten, vertikalen Diode angesteuert wird.

5. Integrierte Halbleiterschaltung nach einem der Ansprüche 1 bis 2,
**dadurch gekennzeichnet,** daß als Schutzelement (7) ein integrierter Thyristor oder IGBT vorgesehen ist, der durch die aus der ersten Zone (8) und der zweiten Zone (9) gebildeten, vertikalen Diode angesteuert wird.

6. Integrierte Halbleiterschaltung nach einem der vorhergehenden Ansprüche,
**dadurch gekennzeichnet,** daß die laterale Querschnittsfläche der ersten Zone (8) größer ist als die laterale Querschnittsfläche der zweiten Zone (9).

7. Verfahren zur Herstellung der zweiten Zone (9) eines Schutzelements (7) nach einem der vorhergehenden Ansprüche,
**dadurch gekennzeichnet,** daß nachfolgende Verfahrensschritte durchgeführt werden:
• es wird eine erste Zone (8), die als vergrabene Schicht in dem Halbleiterkörper (2) ausgebildet ist, bereitgestellt,
• auf den Halbleiterkörper (2) wird eine Dotierungsmaske (16) aufgebracht, wobei:
- die Dotierungsmaske (16) eine Vielzahl von Öffnungen (17) aufweist,
- der maximale Abstand (d) benachbarter Öffnungen (17) kleiner ist als die doppelte Diffusionslänge der einzubringenden Dotieratome,
- die Maskierungschicht (16) derart auf dem Halbleiterkörper (2) positioniert ist, daß die Öffnungen (17) im wesentlichen vertikal über der ersten Zone (8) angeordnet sind,
• die Dotieratome werden in den maskierten Halbleiterkörper (2) eingebracht,
• der dotierte Halbleiterkörper (2) wird getempert.

8. Verfahren nach Anspruch 7,
**dadurch gekennzeichnet,** daß die Dotieratome für die zweite Zone (9) durch Diffusion in den Halbleiterkörper (2) eingebracht werden.

9. Verfahren nach Anspruch 7,
**dadurch gekennzeichnet,** daß die Dotieratome für die zweite Zone (9) durch Ionenimplantation in den Halbleiterkörper (2) eingebracht werden.

10. Dotierungsmaske (16) zur Durchführung des Verfahrens nach einem der Ansprüch 7 bis 9,
**dadurch gekennzeichnet,** daß die Öffnungen (17) eine Querschnittsfläche (A) aufweisen und die Dotierkonzentration in der zweiten Zone (9) über die Querschnittsfläche (A) und/oder über den Abstand (d) genau einstellbar ist.

11. Dotierungsmaske (16) zur Durchführung des Verfahrens nach einem der Ansprüch 7 bis 10,
**dadurch gekennzeichnet,** daß die Öffnungen (17) eine identische Querschnittsfläche (A) aufweisen, wobei deren Abstand (d) in Richtung einer Randzone (23) der Dotiermaske (16) kontinuierlich abnimmt.

12. Dotierungsmaske (16) zur Durchführung des Verfahrens nach einem der Ansprüch 7 bis 10,
**dadurch gekennzeichnet,** daß die Öffnungen (17) in äquidistantem Abstand (d) zueinander angeordnet sind, wobei sich deren Querschnittsfläche (A) in Richtung einer Randzone (23) der Dotiermaske (16) kontinuierlich abnimmt.

13. Verwendung eines Schutzelements (7) für eine integrierte Schaltung nach einem der vorhergehenden Ansprüche in einem Halbleiterspeicher oder in einem Logikbauteil oder in einem Mikrokontroller.
